# EUROPEAN PATENT SPECIFICATION

(11) **EP 0 805 435 B1**
(45) Date of publication and mention of the grant of the patent: **14.08.2002**
(21) Application number: 97302899.6
(22) Date of filing: 28.04.1997
(51) Int. Cl.: G10L 19/14

(54) **Signal quantiser for speech coding**
Signalquantisierer für die Sprachkodierung
Quantificateur de signal pour le codage de la parole

(30) Priority: 30.04.1996 US 640292
(43) Date of publication of application: 05.11.1997
(73) Proprietor: TEXAS INSTRUMENTS INCORPORATED, Dallas, Texas 75243 (US)
(72) Inventor: McCree, Alan V., Dallas, 75248 Texas (US)
(74) Representative: Holt, Michael

(56) References cited:
- EP-A- 0 573 398
- WO-A-92/11627
- MCCREE A V ET AL: "A MIXED EXCITATION LPC VOCODER MODEL FOR LOW BIT RATE SPEECH CODING" IEEE TRANSACTIONS ON SPEECH AND AUDIO PROCESSING, vol. 3, no. 4, July 1995, pages 242-249, XP000633068

## Description

This invention relates to a quantizer and more particularly to an improved signal quantizer suitable for use in speech coding.

### BACKGROUND OF THE INVENTION

Many signals exhibit a slowly-varying, predictable behavior over time, so that changes in the amplitude of the signal are typically small for consecutive time samples. For these signals, quantizers can be developed which are more efficient than simple scalar quantization. For example, a quantization method has previously been proposed in an article by A. McCree and TB Barnwell III entitled "A Mixed Excitation LPC Vocoder Model for Low Bit Rate Speech Coding," IEEE Transactions on Speech Processing, July 1995, pp. 242-250, which reduces the bit rate for quantization of the gain term in Mixed Excitation Linear Predictive (MELP) speech coder.

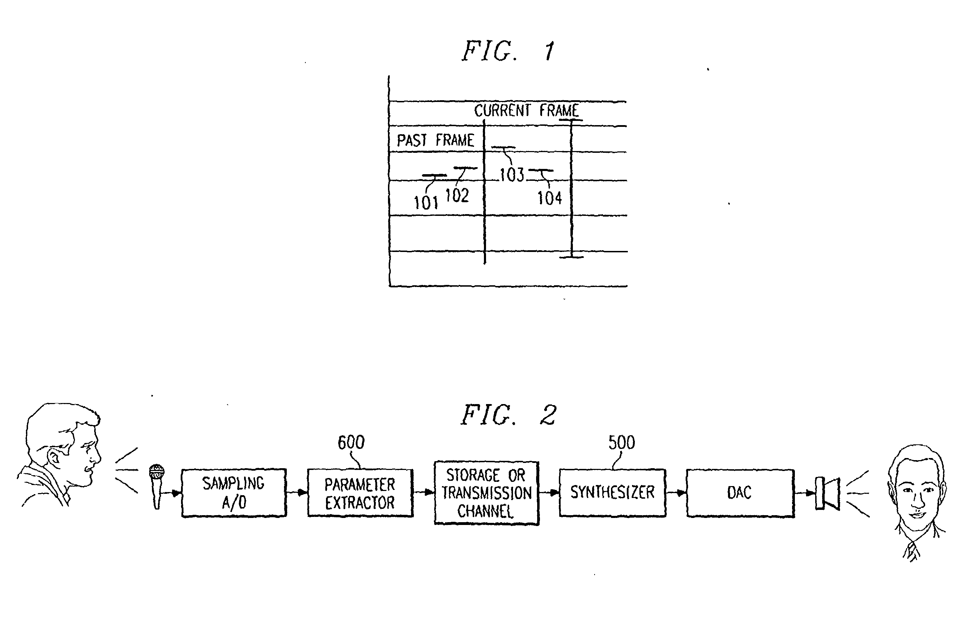

As described in the above cited article, the gain term in the MELP coder typically changes slowly with time, except for occasional large excursions at speech transition such as the beginning of a vowel. Therefore, the gain can be quantized more efficiently when grouped into pairs than when each gain is individually quantized. For each pair of consecutive gain terms, the second term is encoded in the traditional way, with a 5-bit (32 level) uniform scalar quantizer covering the entire dynamic range of the gain signal. However, the first term is encoded using only 3 bits (8 levels) and a more limited dynamic range based on the already transmitted values for the second term and the previous value of gain. This method reduces the bit rate of the gain quantization in the MELP coder with no perceivable drop in the quality of the speech signal.
This operation is illustrated in Fig. 1 where level 101 represents the level of the first term in the past frame and 102 represents the second term in the past frame, 103 represents the first term in the present frame and 104 represents the level in the second term in the present frame. The second term 102 with 32 levels covers the entire range 10 dB (decibel) to 77 dB, for example.
The first term with 3 bits is from 6 dB above the maximum to 6 dB below the minimum of the levels of the neighboring second terms. The actual step size is 1/8th of the range. The step size is dependent on the levels of each frame.

Unfortunately, this quantizer does not perform well in the presence of noisy digital channels. When bit errors are introduced, the decoded value for the second gain term can contain very large errors due to the wide dynamic range of this signal, resulting in annoying "pops" in the output speech.

In accordance with one embodiment of the present invention, applicant presents an improved quantizer which results in better performance for noisy communication channels.

### SUMMARY OF THE INVENTION

A method for quantizing a signal and a quantizer as claimed in claims 1-15 is provided by taking advantage of the expected input signal characteristics. In accordance with one embodiment of the present invention an improved quantizer is provided wherein the value of a first term representing a first time period is provided by first encoder and a value of a second term during a second adjacent time period is provided by a second encoder. The quantizer includes an encoder means responsive to a steady state condition to generate a special code. The quantizer includes a decoder with means responsive to the special code to provide an average of decoded second terms for a first term.

These and other features of the invention that will be apparent to those skilled in the art from the following detailed description of the invention, taken together with the accompanying drawings.

### DESCRIPTION OF THE DRAWINGS

In the drawing:
Fig. 1 illustrates frames and first and second terms in frames;
Fig. 2 is a block diagram of a communications system;
Fig. 3 is a block diagram of an analyzer in the communications system of Fig. 2;
Fig. 4. is a block diagram of the improved quantizer according to one embodiment of the present invention;
Fig. 5 is a flow chart of the processor operation of Fig. 4;
Fig. 6 illustrates a synthesizer in accordance with one embodiment of the present invention;
Fig. 7 is a functional diagram of the decoder in the synthesizer of Fig. 6; and
Fig. 8 is a flow diagram for the operation of the decoder of Fig. 7.

### DETAILED DESCRIPTION OF ONE EMBODIMENT OF THE PRESENT INVENTION

Human speech consists of a stream of acoustic signals with frequencies ranging up to roughly 20 KHz; however, the band of about 100 Hz to 5 KHz contains the bulk of the acoustic energy.
Telephone transmission of human speech originally consisted of conversion of the analog acoustic signal stream into an analog voltage signal stream (e.g., by using a microphone) for transmission and conversion back to an acoustic signal stream (e.g., use a loudspeaker). The electrical signals would be bandpass filtered to retain only the 300 Hz to 4 KHz frequency band to limit bandwidth and avoid low frequency problems.
However, the advantages of digital electrical signal transmission has inspired a conversion to digital telephone transmission beginning in the 1960s. Digital telephone signals are typically derived from sampling analog signals at 8 KHz and nonlinearly quantizing the samples with 8 bit codes according to the µ-law (pulse code modulation, or PCM). A clocked digital-to-analog converter and compounding amplifier reconstruct an analog electric signal stream from the stream of 8-bit samples. Such signals require transmission rates of 64 Kbps (kilobits per second) and this exceeds the former analog signal transmission bandwidth.

The storage of speech information in analog format (for example, on magnetic tape in a telephone answering machine) can likewise be replaced with digital storage. However, the memory demands can become overwhelming: 10 minutes of 8-bit PCM sampled at 8 KHz would require about 5 MB (megabytes) of storage.

The demand for lower transmission rates and storage requirements has led to development of compression for speech signals. One approach to speech compression models the physiological generation of speech and thereby reduces the necessary information to be transmitted or stored. In particular, the linear speech production model presumes excitation of a variable filter (which roughly represents the vocal tract) by either a pulse train with pitch period P (for voiced sounds) or white noise (for unvoiced sounds) followed by amplification to adjust the loudness.

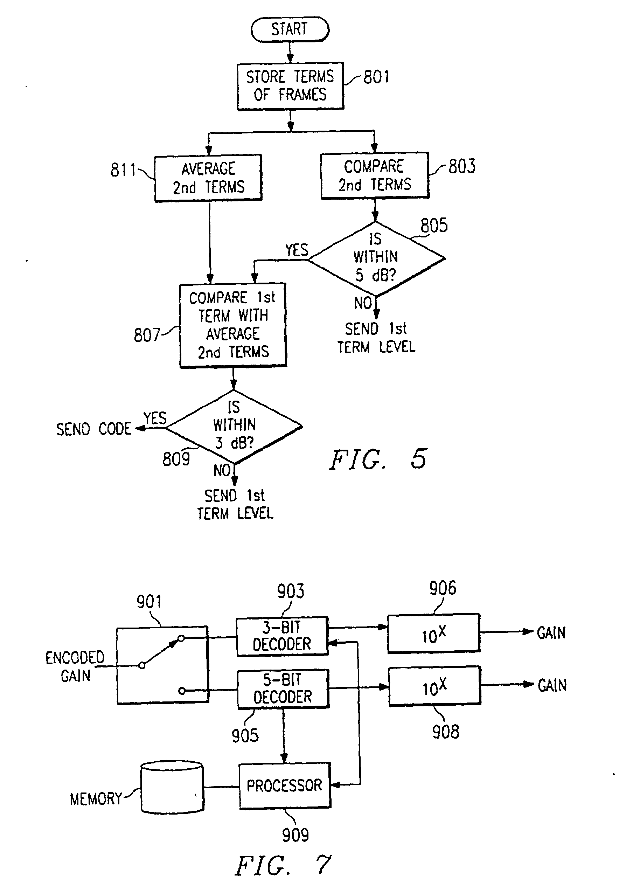

The application cited above of A. McCree entitled "Mixed Excitation Linear Prediction with Fractional Pitch" filed March 3, 1994, is one such low bit rate speech coder. Figure 7 of that application describes the overall system and is shown herein as Figure 2. The input speech is sampled by an analog to digital converter and the parameters are encoded in the analyzer 600 and sent via the storage and transmission channel to the synthesizer 500 . The decoded signals are then converted back to analog signals by the digital to analog converter for output to a speaker. Fig. 5 of the reference application illustrates the synthesizer. The synthesizer is also illustrated in applicant's article in IEEE Trans. on Speech and Audio Processing Vol. 3 ,N0.4, July 1995 in an article entitled "A mixed Excitation LPC Vocoder Model for Low Bit rate Speech Coding".

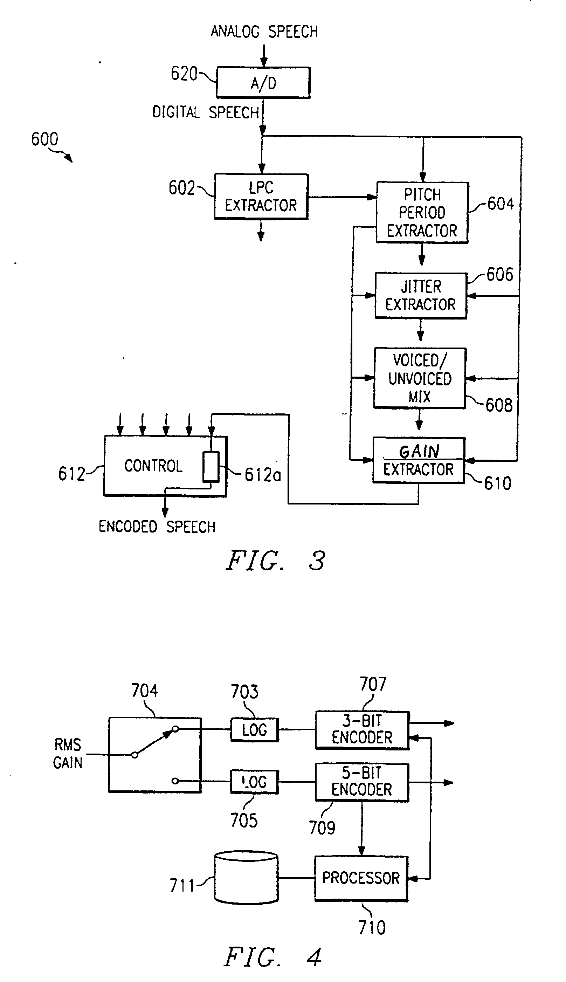

Fig. 3 herein (like Fig. 6 in the above cited application)illustrates the analyzer 600. The analyzer 600 receives the analog speech and converts that to digital speech using analog to digital converter 620. The digitized speech is applied to an LPC extractor 602, pitch period extractor 604, jitter extractor 606, voiced /unvoiced mixture control extractor 608, and gain extractor 610. An encoder(controller)612 assembles the block outputs and clocks them out as a sample stream. The five arrows into encoder 612 are from the five output blocks. The encoder for gain 610 uses the quantizer system 612a according to the present invention.

As discussed in the background the encoder provides two output levels each frame. As illustrated in Fig. 1 the level 101 is the first term in the past frame and level 102 is the second term in the past frame. The levels 103 and 104 represent the first and second terms of the present frame. In order to reduce the bit rate of gain quantization the first term is encoded using only three bits and the second term by using five bits. The second term with 32 levels covers the entire range of levels from 10 dB to 77 dB. The first term with only three bits has a range of from 6 dB above the maximum to 6 dB below the minimum of the levels of the neighboring second terms.

As discussed in the background this system does not perform well in the presence of noisy digital channels. When bit errors are introduced, the decoded value for the second gain term can contain very large errors due to the wide dynamic range of this signal. This causes annoying "pops".

Applicants' new quantization method and system herein avoids this problem by taking advantage of the expected steady-state behavior of the gain signal. Typically, the gain does not vary much over the two terms in the current frame and the previous gain term.
For these cases, we introduce a special quantization code for the first gain term to represent a steady-state frame. When the decoder in the synthesizer 500 detects the special steady-state code, it simply uses an interpolated value for the first gain term based on the second gain term value and transmitted second and previous gain value. The frames are stored before being transmitted so the second term of the same frame is available for first term calculation. This method improves the performance of the quantizer during steady-state frames under bit errors by introducing redundancy to the transmitted values. For these steady-state frames, the decoder will still produce a steady-state output during bit errors as long as at least some of the information bits are uncorrupted. As long as either the steady-state code or the second gain term is correctly received, the decoder will not introduce significant excursions into the output gain signal. During speech frames which are not steady-state, bit errors will tend to make the decoder of this new quantizer produce a smoother output than was intended. However, steady-state frames occur much more frequently and are more perceptually important than transitional frames, so the performance improvement obtained for the steady-state frames far outweighs any slight quality degradation in bit error performance for transitional frames.

This quantizer has been implemented in a 2.4 kb/s MELP coder, and compared against the previous quantization method. In informal listening tests, the new method provides a clear improvement during bit error conditions, while having no negative effect on clean channel performance.

Referring to Fig. 4 there is illustrated the encoder portion of the quantizer system according to one embodiment of the present invention. The input speech is converted to digital at A/D converter 620(Fig. 3) and applied to gain extractor 610. The speech gain is estimated twice per frame using an RMS power level detector of the input speech. For voiced frames the estimation window is adjusted to be a multiple of the pitch period. The gain output from extractor 610 is applied to encoder 612a. At encoder 612a the converted speech gain over the first half of each frame (first term) is switched via switch 704 to log function detector 703 and over the second half of the frame to log function 705.
The log function 703 and 705 may be provided by a log look-up table where for a given gain level a log gain is provided. The output from log function 703 is applied to a 3-bit uniform (equal size step) scalar encoder 707 to provide the first term and the output from log function 705 is applied to 5-bit uniform scalar encoder 709 to provide the second term. The second term is for the whole range from minimum (10 dB for example) to maximum (76 dB the example) in 32 steps as represented by the 5-bits. The encoder 707 is capable of a range of 7 levels with three bits. The first term with only three bits has a range of from 6 dB above the maximum to 6 dB below the minimum of the levels of the neighboring second terms. The eighth possible level is reserved for a special code. A processor 710 is coupled to the 3-bit encoder and 5-bit encoder . The processor is coupled to storage 711. The processor 707 is programmed to follow the procedure of the flow chart of Fig. 5.

The processor stores (steps 801) the terms (gain levels) of the frames in storage 711. The second term of the current frame is compared (step 803) to the second term of the previous frame and the system determines if these two terms have a gain level within 5 dB of the other. If so (yes at step 805), the processor compares (step 807) the value of the first term of the current frame (the intermediate term) to average gain levels of the second terms of the current and previous frames (the halfway point) and if it is within 3 dB of the average gain level (807) then the special steady state code is sent from the 3-bit decoder. The second term (past and current) are averaged at step 811 and sent to comparator 807. If the conditions are not met, the system behaves as before with only seven levels available for the first term since the 8th level is used for the special code.

Referring to Fig. 6 there is illustrated a synthesizer according to one embodiment of the present invention. For the example in the present invention this is the MELP system as shown in Fig. 5 of the above cited application incorporated herein by reference.

Fig. 6 illustrates in functional block form a first preferred embodiment speech synthesizer, generally denoted by reference numeral 500, as including periodic pulse train generator 502 controlled by a pitch period input, a pulse train amplifier 504 controlled by a gain input, pulse jitter generator 506 controlled by a jitter flag input, a pulse filter 508 controlled by five band voiced/unvoiced mixture inputs, white noise generator 512, noise amplifier 514 also controlled by the same gain input, noise filter 518 controlled by the same five band mixture inputs, adder 520 to combine the filtered pulse and noise excitations, linear prediction synthesis filter 530 controlled by 10 LSP inputs, adaptive spectral enhancement filter 532 which adds emphasis to the formants, and pulse dispersion filter 534. Filters 508 and 518 plus adder 520 form a mixer to combine the pulse and noise excitations.

The control signals (LPC coefficients, pitch period, gain, jitter flag, and pulse/noise mixture) derive from analysis of input speech. Fig. 3 illustrated in functional block form a first preferred embodiment speech analyzer, denoted by reference numeral 600, as including LPC extractor 602, pitch period extractor 604, jitter extractor 606, voiced/unvoiced mixture control extractor 608, gain extractor 610, and controller 612 for assembling the block outputs and clocking them out as a sample stream. Sampling analog-to-digital converter 620 could be included to take input analog speech and generate the digital samples at a sampling rate of 8 KHz.

The encoded speech may be received as a serial bit stream and decoded into the various control signals by controller and clock 536. The clock provides for synchronization of the components, and the clock signal may be extracted from the received input bit stream. For each encoded frame transmitted via updating of the control inputs, synthesizer 500 generates a frame of synthesized digital speech which can be converted to frames of analog speech by synchronous digital-to-analog converter 540. Hardware or software or mixed (firmware) may be used to implement synthesizer 500. For example, a digital signal processor such as a TMS320C30 from Texas Instruments can be programmed to perform both the analysis and synthesis of the preferred embodiment functions in essentially real time for a 2400 bit per second encoded speech bit stream. Alternatively, specialized hardware (e.g., ALUs for arithmetic and logic operations with filter coefficients held in ROMs, RAM for holding encoded parameters such as LPC coefficients and pitch, sequences for control, LPC and LSP conversion and back special circuits, a crystal oscillator for clocking, and so forth) which may hardwire some of the operations could be used. Also, a synthesizer alone may be used with stored encoded speech. The encoded speech is applied to control and clock decoder 536 and the five outputs are the gain control, pitch period, extractor, jitter flag, LPC coefficients and voiced/unvoiced mix. The decoding occurs in control and clock decoder 536a. For the gain function, the decoder comprises the subsystem of Fig. 7. The encoded input is switched by switch 901 to 3-bit decoder 903 and 5-bit decoder 905 every half frame to provide the first and second terms. The decoder 903 contains, for example, a look-up table that for a 3-bit input term provides a given gain level. The decoder 905 for the 5-bit input term provides a given gain level. An anti-log function of value is calculated at 906 and 908 and provided as gain to the amplifier 504 and 514 in Fig. 6. The anti-log can also be provided by a look-up table. A processor 909 and memory 910 are coupled to the decoder 903 and 905.

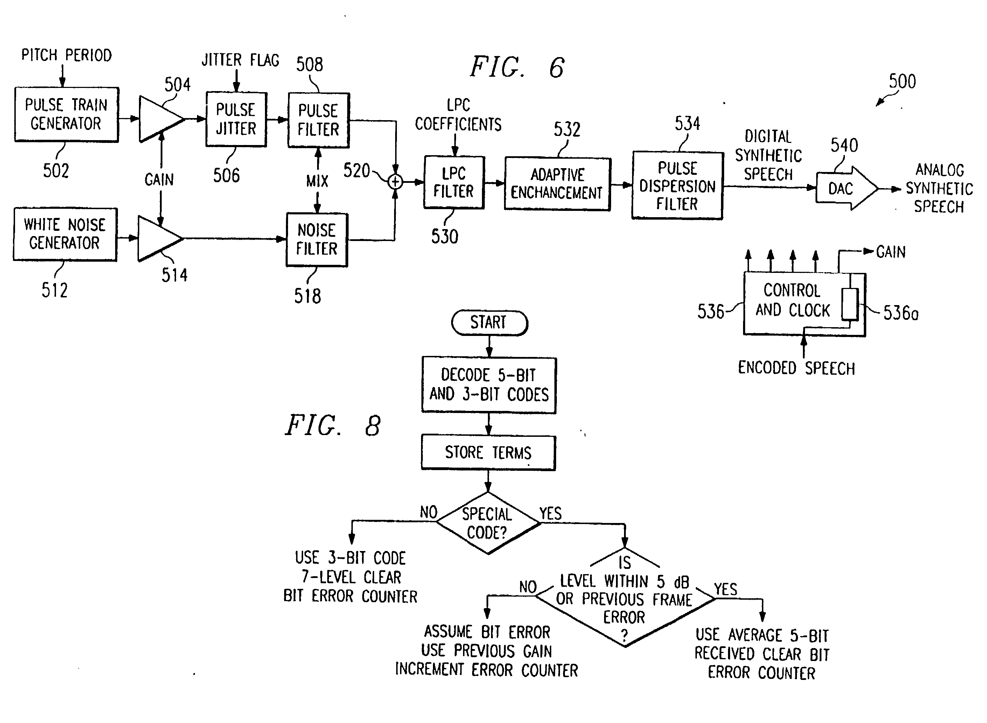

The processor 909 stores the current and previous second term gain and averages these gains. The processor looks for the special code and if it does receive the special code as shown in Fig. 8 it averages the value of the received previous and current second gain terms and compares this to the previous gain and if within 5 dB provides the average value to the gain in the synthesizer. If not and if the previous frame was not in error, then it is assumed there was a bit error and a channel error counter is incremented. The previous second frame gain value is repeated for both terms of the current frame. To ensure that the decoder correctly tracks the encoder, the processor does not implement the repeat mechanism if the previous frame was in error.

The pseudo code for the encoder and decoder follows:
ENCODER
Code second gain term using 5-bit quantizer
If (second gain within 5 dB of previous value AND
first gain within 3 dB of interpolated value)
transmit special interpolation code for first gain
Else
code first gain with 7 remaining quantizer levels
Endif
DECODER
Decode second gain term
Decode first gain term
If interpolation code received and average of the received and previous second term gain is within 5 dB from previous second term gain provide average gain
If (interpolation code received AND
second gain more than 5 dB from previous gain AND
previous frame was not in error)
assume channel error was introduced to steady-state frame
increment channel error counter
repeat previous gain value of second term
clear channel error counter
Else
clear channel error counter
Endif

Although the present invention and its advantages have been described in detail, it should be understood that various changes, substitutions and alterations can be made herein without departing from the scope of the invention as defined by the appended claims.

## Claims

1. A quantizing system comprising:
a first encoder for providing each frame a first encoded signal representing a value over a first time period;
a second encoder for providing each frame a second encoded signal representing a value over a second adjacent time period;
means responsive to said second coded signal and said first coded signal for determining a steady state condition and for generating a special code signal when determining said steady state condition; and
a first decoder responsive to said first encoded signal for providing a first decoded value corresponding to said first encoded signal for said first time period and a second decoder responsive to said second decoded signal for providing a second decoded value corresponding to said second encoded signal for said second time period and
a third decoder responsive to said special code signal for providing as a valve for the first time period in place of said first decoder output a third decoded value equal to the average of said received present and previous second decoded values from said second decoder.

2. A quantizing system as claimed in Claim 1 and wherein said first time period is a first half of a frame period.

3. A quantizing system as claimed in Claim 1 or Claim 2 and wherein said second time period is a second half of a frame.

4. A quantizing system as claimed in any preceding claim, wherein said values are gain values or levels.

5. A quantizing system of any preceding claim wherein said means for generating said special code comprises means for comparing said second values from said second encoder before and after said first values from said first encoder value and if the second values are within a first range of values comparing the first value from said first encoder to the average of the encoded second values from the second encoder and generating said special code if the average of the second values and first value are within a second range.

6. A quantizing system of Claim 5, wherein said first range is within 5 dB and said second range is 3 dB.

7. A quantizing system of any preceding claim wherein said third decoder includes means for averaging the present and previous second values from said second decoder to provide an average gain value and means for comparing said average gain value to a previous gain value and providing said average if within a certain range.

8. A quantizing system of Claim 7 wherein said range is within 5 dB.

9. A quantizing system of any preceding claim wherein said third decoder includes means responsive to said average gain value not being within a predetermined range providing a signal indicating a bit error.

10. A speech communications system comprising :
an analog to digital converter responsive to audio speech signals for providing digital signals representing samples of analog signals;
a quantizing system as claimed in any preceding claim and a communications channel coupled to said encoders for transmissions said speech signals.

11. A method of quantizing a signal comprising the steps of:
encoding each frame a first term signal representing an RMS value over a first half of a sampled frame to provide a first encoded signal;
encoding each frame a second term signal representing an RMS value over a second half of a sampled frame to provide a second encoded signal;
generating a special code signal representing a steady state condition of second term signals neighboring said first term signal; and
decoding said first and second encoded signals and said special code signal to provide for said second encoded signal said second term signal, for said first encoded signal said first term signal unless said special code signal is decoded and, if said special code signal is decoded, providing for said first term signal an average signal being the average of said decoded second encoded signals of received previous and current frames.

12. The method of Claim 11, wherein said decoding step includes comparing said average signal to decoded said second term signal to determine if within a given range and if so providing said average signal and if outside said range providing an error signal.

13. The method of Claim 11 or Claim 12, wherein said generating step includes the steps of comparing said second term signals neighboring said first term signal, averaging said second term signals, and if said second term signal are within a given range comparing said first term signal to said average of said second term signals and if with a second range generating said special code.

14. The method of Claim 13, wherein said first range is 5 dB and said second range is 3 dB.

15. A method of communicating signals comprising the steps of:
sampling and analyzing said signals over a frame period of time to provide each frame a first term signal and a second term signal representing an RMS value over a first and second half of said frame;
encoding each frame said first term signal representing an RMS value over a first half of a sampled frame to provide a first encoded signal;
quantizing said signal as claimed in any of Claims 11 to 14 transmitting said encoded first and second encoded signals and said special coded signals over a communications channel; and
synthesizing and converting said first and said term signals and said average signal to provide a synthesized representation of said signals analyzed and sampled.

## Patentansprüche

1. Quantisierungssystem, mit:
einem ersten Codierer, der für jeden Rahmen ein erstes codiertes Signal schafft, das einen Wert über einer ersten Zeitperiode repräsentiert;
einem zweiten Codierer, der für jeden Rahmen ein zweites codiertes Signal schafft, das einen Wert über einer zweiten, angrenzenden Zeitperiode repräsentiert;
Mitteln, die als Reaktion auf das zweite codierte Signal und das erste codierte Signal einen stationären Zustand bestimmen und ein spezielles Codesignal erzeugen, wenn der stationäre Zustand bestimmt wird; und
einem ersten Decodierer, der als Reaktion auf das erste codierte Signal einen ersten decodierten Wert schafft, der dem ersten codierten Signal für die erste Zeitperiode entspricht, und einem zweiten Decodierer, der als Reaktion auf das zweite decodierte Signal einen zweiten decodierten Wert schafft, der dem zweiten codierten Signal für die zweite Zeitperiode entspricht, und
einem dritten Decodierer, der als Reaktion auf das spezielle Codesignal als Wert für die erste Zeitperiode anstatt des Ausgangssignals des ersten Decodierers einen dritten decodierten Wert schafft, der gleich dem Durchschnitt aus den empfangenen momentanen und vorhergehenden zweiten decodierten Werten vom zweiten Decodierer ist.

2. Quantisierungssystem nach Anspruch 1, bei dem die erste Zeitperiode eine erste Hälfte einer Rahmenperiode ist.

3. Quantisierungssystem nach Anspruch 1 oder Anspruch 2, bei dem die zweite Zeitperiode eine zweite Hälfte eines Rahmens ist.

4. Quantisierungssystem nach einem vorhergehenden Anspruch, bei dem die Werte Verstärkungswerte oder -pegel sind.

5. Quantisierungssystem nach einem vorhergehenden Anspruch, bei dem die Mittel zum Erzeugen des speziellen Codes Mittel umfassen, die die zweiten Werte vom zweiten Codierer vor und nach den ersten Werten vom ersten Codiererwert vergleichen und, falls die zweiten Werte innerhalb eines ersten Wertebereichs liegen, den ersten Wert vom ersten Codierer mit dem Durchschnitt der codierten zweiten Werte vom zweiten Codierer vergleichen und den speziellen Code erzeugen, falls der Durchschnitt der zweiten Werte und der erste Wert innerhalb eines zweiten Bereichs liegen.

6. Quantisierungssystem nach Anspruch 5, bei dem der erste Bereich innerhalb von 5 dB liegt und der zweite Bereich 3 dB beträgt.

7. Quantisierungssystem nach einem vorhergehenden Anspruch, bei dem der dritte Decodierer Mittel, die aus den momentanen und vorhergehenden zweiten Werten vom zweiten Decodierer den Durchschnitt bilden, um einen Durchschnittsverstärkungswert zu schaffen, und Mittel, die den Durchschnittsverstärkungswert mit einem vorhergehenden Verstärkungswert vergleichen und den Durchschnitt bilden, falls er innerhalb eines bestimmten Bereichs liegt, umfaßt.

8. Quantisierungssystem nach Anspruch 7, bei dem der Bereich innerhalb von 5 dB liegt.

9. Quantisierungssystem nach einem vorhergehenden Anspruch, bei dem der dritte Decodierer Mittel enthält, die als Reaktion darauf, daß der Durchschnittsverstärkungswert nicht innerhalb eines vorgegebenen Bereichs liegt, ein Signal erzeugen, das einen Bitfehler angibt.

10. Sprachkommunikationssystem, mit:
einem Analog/Digital-Umsetzer, der als Reaktion auf Audiosprachsignale digitale Signale schafft, die Abtastwerte von analogen Signalen repräsentieren;
einem Quantisierungssystem nach einem vorhergehenden Anspruch und einem Kommunikationskanal, der mit den Codierern gekoppelt ist, um die Sprachsignale zu übertragen.

11. Verfahren zum Quantisieren eines Signals, das die Schritte umfaßt, bei denen:
für jeden Rahmen ein Signal eines ersten Terms codiert wird, das einen RMS-Wert über einer ersten Hälfte eines abgetasteten Rahmens repräsentiert, um ein erstes codiertes Signal zu schaffen;
für jeden Rahmen ein Signal eines zweiten Terms codiert wird, das einen RMS-Wert über einer zweiten Hälfte eines abgetasteten Rahmens repräsentiert, um ein zweites codiertes Signal zu schaffen;
ein spezielles Codesignal erzeugt wird, das einen stationären Zustand von Signalen des zweiten Terms repräsentiert, die zu dem Signal des ersten Terms benachbart sind; und
die ersten und zweiten codierten Signale und das spezielle Codesignal decodiert werden, um für das zweite codierte Signal das Signal des zweiten Terms zu schaffen, für das erste codierte Signal das Signal des ersten Terms zu schaffen, wenn das spezielle Codesignal nicht decodiert wird, und, falls das spezielle Codesignal decodiert wird, für das Signal des ersten Terms ein Durchschnittssignal zu schaffen, das den Durchschnitt aus den decodierten zweiten codierten Signalen empfangener vorhergehender und momentaner Rahmen ist.

12. Verfahren nach Anspruch 11, bei dem im Decodierungsschritt das Durchschnittssignal mit dem decodierten Signal des zweiten Terms verglichen wird, um zu bestimmen, ob es innerhalb eines gegebenen Bereichs liegt, und um, wenn dem so ist, das Durchschnittssignal zu scharfen, und um dann, wenn es außerhalb dieses Bereichs liegt, ein Fehlersignal zu schaffen.

13. Verfahren nach Anspruch 11 oder Anspruch 12, bei dem der Erzeugungsschritt die Schritte enthält, bei denen die Signale des zweiten Terms, die zu dem Signal des ersten Terms benachbart sind, verglichen werden, die Signale des zweiten Terms gemittelt werden und, falls das Signal des zweiten Terms innerhalb eines gegebenen Bereichs liegt, das Signal des ersten Terms mit dem Durchschnittswert der Signale des zweiten Terms verglichen wird, und, falls es innerhalb eines zweiten Bereichs liegt, der spezielle Code erzeugt wird.

14. Verfahren nach Anspruch 13, bei dem der erste Bereich 5 dB beträgt und der zweite Bereich 3 dB beträgt.

15. Verfahren für den Austausch von Signalen, das die Schritte umfaßt, bei denen:
die Signale über eine Rahmen-Zeitperiode abgetastet und analysiert werden, um für jeden Rahmen ein Signal eines ersten Terms und ein Signal eines zweiten Terms zu schaffen, die einen RMS-Wert über eine erste bzw. eine zweite Hälfte des Rahmens repräsentieren;
für jeden Rahmen das Signal des ersten Terms, das einen RMS-Wert über eine erste Hälfte eines abgetasteten Rahmens repräsentiert, codiert wird, um ein erstes codiertes Signal zu schaffen;
das Signal nach einem der Ansprüche 11 bis 14 quantisiert wird und die codierten ersten und zweiten Signale sowie die speziellen Codesignale über einen Kommunikationskanal gesendet werden; und
die Signale des ersten und des zweiten Terms sowie das Durchschnittssignal synthetisiert und umgesetzt werden, um eine synthetisierte Darstellung der analysierten und abgetasteten Signale zu erzeugen.

## Revendications

1. Système de quantification comprenant :
un premier codeur pour fournir à chaque trame un premier signal codé représentant une valeur sur une première période de temps ;
un second codeur pour fournir à chaque trame un second signal codé représentant une valeur sur une seconde période de temps adjacente ;
un moyen apte à répondre audit second signal codé et audit premier signal codé pour déterminer une condition de régime permanent et pour générer un signal de code spécial lors de la détermination de ladite condition de régime permanent ; et
un premier décodeur apte à répondre audit premier signal codé pour fournir une première valeur décodée correspondant audit premier signal codé pour ladite première période de temps et un second décodeur apte à répondre audit second signal décodé pour fournir une seconde valeur décodée correspondant audit second signal codé pour ladite seconde période de temps et
un troisième décodeur apte à répondre audit signal de code spécial pour fournir comme valeur pour la première période de temps à la place de ladite première sortie de décodeur une troisième valeur décodée égale à la moyenne desdites secondes valeurs décodées précédente et actuelle reçues dudit second décodeur.

2. Système de quantification selon la revendication 1, et dans lequel ladite première période de temps est une première moitié d'une période de trame.

3. Système de quantification selon la revendication 1 ou la revendication 2, et dans lequel ladite seconde période de temps est une seconde moitié d'une trame.

4. Système de quantification selon l'une quelconque des revendications précédentes, dans lequel lesdites valeurs sont des valeurs ou des niveaux de gain.

5. Système de quantification de l'une quelconque des revendications précédentes, dans lequel ledit moyen pour générer ledit code spécial comprend un moyen pour comparer lesdites secondes valeurs dudit second codeur avant et après lesdites premières valeurs de ladite première valeur de codeur et si les secondes valeurs sont à l'intérieur d'une première plage de valeurs pour comparer la première valeur dudit premier codeur à la moyenne des secondes valeurs codées du second codeur et pour générer ledit code spécial si la moyenne des secondes valeurs et de la première valeur sont à l'intérieur d'une seconde plage.

6. Système de quantification selon la revendication 5, dans lequel ladite première plage est comprise dans 5 dB et ladite seconde plage est comprise dans 3 dB.

7. Système de quantification selon l'une quelconque des revendications précédentes, dans lequel ledit troisième décodeur inclut un moyen pour moyenner les secondes valeurs précédente et actuelle dudit second décodeur pour fournir une valeur de gain moyenne et un moyen pour comparer ladite valeur de gain moyenne à une valeur de gain précédente et pour fournir ladite moyenne si elle est à l'intérieur d'une certaine plage.

8. Système de quantification selon la revendication 7, dans lequel ladite plage est de comprise dans 5 dB.

9. Système de quantification selon l'une quelconque des revendications précédentes, dans lequel ledit troisième décodeur inclut un moyen apte à répondre à ladite valeur de gain moyenne n'étant pas à l'intérieur d'une plage prédéterminée fournissant un signal indiquant une erreur sur des bits.

10. Système de communications par la parole comprenant :
un convertisseur analogique-numérique apte à répondre à des signaux de parole audio pour fournir des signaux numériques représentant des échantillons de signaux analogiques ;
un système de quantification selon l'une quelconque des revendications précédentes, et une voie de télécommunications couplée auxdits codeurs pour transmettre lesdits signaux de parole.

11. Procédé de quantification d'un signal comprenant les étapes de :
codage pour chaque trame d'un premier signal de terme représentant une valeur efficace sur une première moitié d'une trame échantillonnée pour fournir un premier signal codé ;
codage pour chaque trame d'un second signal de terme représentant une valeur efficace sur une seconde moitié d'une trame échantillonnée pour fournir un second signal codé ;
génération d'un signal de code spécial représentant une condition en régime permanent de seconds signaux de terme voisins dudit premier signal de terme ; et
décodage desdits premier et second signaux codés et dudit signal de code spécial pour fournir en tant que ledit second codé, ledit second signal de terme, ledit premier signal codé ledit premier signal de terme à moins que ledit signal de code spécial ne soit décodé et, si ledit signal de code spécial est décodé, pour fournir en tant que ledit premier signal de terme, un signal moyen étant la moyenne desdits seconds signaux codés décodés de trames précédente et actuelle reçues.

12. Procédé selon la revendication 11, dans lequel ladite étape de décodage inclut la comparaison dudit signal moyen audit second signal de terme décodé pour déterminer s'il est à l'intérieur d'une plage donnée et s'il en est ainsi la fourniture dudit signal moyen et s'il est à l'extérieur de ladite plage la fourniture d'un signal d'erreur.

13. Procédé selon la revendication 11 ou la revendication 12, dans lequel ladite étape de génération inclut les étapes de comparaison desdits seconds signaux de terme voisins dudit premier signal de terme, de moyennage desdits seconds signaux de terme, et si lesdits seconds signaux de terme sont à l'intérieur d'une plage donnée de comparaison dudit premier signal de terme à ladite moyenne desdits seconds signaux de terme et s'il est à l'intérieur d'une seconde plage de génération dudit code spécial.

14. Procédé selon la revendication 13, dans lequel ladite première plage est de 5 dB et ladite second plage est de 3 dB.

15. Procédé de signaux de communication de signaux comprenant les étapes de :
échantillonnage et analyse desdits signaux sur une période de temps de trame pour fournir à chaque trame un premier signal de terme et un second signal de terme représentant une valeur efficace sur une première et une seconde moitié de ladite trame ;
codage pour chaque trame dudit premier signal de terme représentant une valeur efficace sur une première moitié d'une trame échantillonnée pour fournir un premier signal codé ;
quantification dudit signal selon l'une quelconque des revendications 11 à 14, pour transmettre lesdits premiers et seconds signaux codés et lesdits signaux codés spéciaux sur une voie de communications ; et
synthèse et conversion dudit premier et desdits signaux de terme et dudit signal moyen pour fournir une représentation synthétisée desdits signaux analysés et échantillonnés.
